# EUROPEAN PATENT APPLICATION

(11) **EP 1 830 622 A1**
(43) Date of publication of application: **05.09.2007**
(21) Application number: 05806710.9
(22) Date of filing: 18.11.2005
(51) Int. Cl.: H05K 9/00, H01F 1/00, H01F 1/20, H01F 1/26

(54) **RUBBER COMPOSITION FOR WAVE ABSORBER AND WAVE ABSORBING SHEET**

(30) Priority: 30.11.2004 JP 2004346500; 11.03.2005 JP 2005069465; 19.05.2005 JP 2005146869
(71) Applicant: Bridgestone Corporation, Tokyo 104-8340 (JP)
(72) Inventor: OKADA, Osamu, Yokohama Plant, Bridgestone Corp., Yokohama-shi, Kanagawa 2440812 (JP)
(74) Representative: Whalley, Kevin
(86) International application number: PCT/JP2005/021250
(87) International publication number: WO 2006/059502

(57) **Abstract**

This invention provides a rubber composition and an electromagnetic wave absorbing sheet that can realize excellent electromagnetic wave absorbance properties while only having a small thickness and is also excellent in flexibility. The rubber composition comprises 100 parts by weight of a rubber component such as natural rubber and 300 to 1500 parts by weight, preferably 500 to 1000 parts by weight, of carbonyl iron. The incorporation of a predetermined amount of carbonyl iron in the rubber component can realize excellent electromagnetic wave absorbance properties, whereby the thickness of the electromagnetic wave absorbing sheet for providing a necessary electromagnetic wave absorbance amount can be reduced. The rubber composition comprising carbonyl iron incorporated together with the rubber component has low hardness, and is also excellent in flexibility. Accordingly, the rubber composition has good processability, is less likely to break, and is also excellent in durability. The rubber component may contain not less than 5 parts by weight of a weather-resistant rubber in 100 parts by weight of the rubber component and further may contain 1 to 10 parts by weight of carbon black.

## Description

### Technical Field

The present invention relates to a rubber composition for an electromagnetic wave absorber, and an electromagnetic wave absorbing sheet.

### Background Art

With the recent spread of ETCs (Electronic Toll Collection systems), office automation equipment, communication devices and others, electromagnetic waves generated from these instruments have been acknowledged as a problem. More specifically, there are concerns about the impact of electromagnetic waves on the human body, and malfunctions of precision instruments caused by electromagnetic waves are also problematic.

For various types of electronic equipment, a wide variety of electromagnetic wave absorbing materials are under development for the purpose of preventing the emission of internally generated electromagnetic waves and absorbing externally generated electromagnetic waves to eliminate interference between them. The majority of such materials are produced by dispersing powder of a magnetic material such as ferrite, permalloy and sendust into a matrix of rubber or synthetic resin, followed by shaping them into an appropriate form. In general, sheets are adopted as the form because of their usefulness. It is desired that such electromagnetic wave absorbing sheets become thinner and at the same time more excellent in terms of electromagnetic wave absorbance properties. It is also desirable that they are highly flexible so as to be durable, less likely to break, and easily applied to instruments with complicated or irregular shapes and to large instruments.

Performance of absorbing electromagnetic waves is often expressed in terms of the electromagnetic wave absorbance amount or other quantities. To increase this electromagnetic wave absorbance amount, it is required to increase the amount of magnetic materials existing on the path of the electromagnetic waves in principle. However, if an increased amount of magnetic material is present in a thin sheet, in other words, if materials forming the sheet include powder of magnetic materials at high density, the flexibility of the sheet is significantly reduced. On the other hand, if magnetic materials are incorporated at low levels, it is required to thicken the sheet to achieve desired properties in terms of electromagnetic wave absorbance amount.

Electromagnetic wave absorbing sheets that are thin and have sufficiently high performance in both electromagnetic wave absorbance properties and flexibility have not been provided yet.

Electromagnetic wave absorbing sheets are used continuously for a long period of time, and thus it is hoped that they have excellent resistance to environmental conditions such as ozone, weather and heat. Rubber compositions for electromagnetic wave absorbers that contain natural rubber as the rubber component are less resistant to environmental conditions such as ozone, weather and heat, and age rapidly, so that they have a disadvantage of being likely to break due to deterioration in integrity.

### Disclosure of Invention

The present invention provides a rubber composition for an electromagnetic wave absorber that is capable of producing a thin electromagnetic wave absorbing sheet with high flexibility and excellent electromagnetic wave absorbance properties, as well as a thin electromagnetic wave absorbing sheet that is excellent in flexibility and electromagnetic wave absorbance properties and formed by shaping the rubber composition for an electromagnetic wave absorber into a sheet.

The rubber composition for an electromagnetic wave absorber of the present invention contains 100 parts by weight of a rubber component and 200 to 1500 parts by weight of carbonyl iron.

By shaping the rubber composition for an electromagnetic wave absorber into a sheet, an electromagnetic wave absorbing sheet is produced.

### Best Mode for Carrying Out the Invention

The rubber composition for an electromagnetic wave absorber of the present invention contains a rubber component and carbonyl iron.

Adding a predetermined amount of carbonyl iron into the rubber component, such as natural rubber, the produced electromagnetic wave absorbing sheet acquires outstanding electromagnetic wave absorbance properties, thereby making it possible to reduce the thickness of the sheet to achieve the desired electromagnetic wave absorbance amount. A rubber composition containing a rubber component, such as natural rubber, and carbonyl iron exhibits lower hardness and outstanding flexibility, thereby being durable, less likely to break and favorable in processability.

An electromagnetic wave absorbing sheet produced from this rubber composition facilitates carrying out of measures to shield against electromagnetic waves on surfaces having various shapes and areas.

Carbonyl iron powder is a fine and almost granular powder whose mean particle diameter is approximately 1 to 10 µm and is obtained from the thermal decomposition of carbonyl iron, an organometallic compound. It provides an excellent electromagnetic wave absorbing material that efficiently absorbs electromagnetic waves through magnetic loss and at the same time absorbs electromagnetic waves as resistance losses through its electric conductivity.

If the amount of carbonyl iron incorporated relative to the rubber component is too low, sufficient electromagnetic wave absorbance properties are not achieved, and if it is too high, the flexibility is likely to be reduced. Therefore, the carbonyl iron accounts for 200 to 1500 parts by weight, preferably 300 to 1500 parts by weight, more preferably 300 to 1000 parts by weight, or most preferably 500 to 1000 parts by weight relative to 100 parts by weight of the rubber component.

Besides the carbonyl iron, several vulcanization agents, auxiliary agents for vulcanization, and if required, other additives that are generally used in rubber compositions, such as vulcanization accelerators, softening agents, anti-aging agents, plasticizers, mold releasing agents, hardening agents, foaming agents and coloring agents are incorporated into the rubber composition for an electromagnetic wave absorber.

The vulcanization agents include, but are not limited to, sulfur, sulfur-containing organic compounds, metal oxides (such as zinc oxide and magnesia) and organic peroxides (such as benzoyl peroxide).

The specific vulcanization accelerators include, but are not limited to, the following compounds:

### [Aldehyde ammonia]

- AC:: Acetaldehyde ammonia
- Hexa:: Hexamethylenetetramine

### [Aldehyde amine]

- K:: Acetaldehyde aniline
- 8:: Butyraldehyde aniline

### [Guanidine]

- D (DPG):: Diphenyl guanidine
- DT (DOTG):: Di-o-tolyl guanidine
- BG:: o-Tolyl biguanide

### [Thiazole]

- M:: 2-Mercaptobenzothiazole
- DM:: Dibenzothiazyl disulfide
- MZ:: Zinc salt of 2-mercaptobenzothiazole
- CZ:: N-cyclohexyl-2-benzothiazolesulfenamide
- NOBS:: N-oxydiethylene-2-benzothiazylsulfenamide

### [Thiuram]

- TT:: Tetramethylthiuram disulfide
- TS:: Tetramethylthiuram monosulfide

### [Dithiocarbamate]

- P:: Pipecoline methylpentamethylene dithiocarbamate
- PZ:: Zinc dimethyldithiocarbamate
- EZ:: Zinc diethyldithiocarbamate
- BZ:: Zinc dibutyldithiocarbamate
- PX:: Zinc ethylphenyldithiocarbamate
- SDC:: Sodium diethyldithiocarbamate
- TP:: Sodium dibutyldithiocarbamate

In general, the vulcanization agent is incorporated so as to account for 0.1 to 10 parts by weight, or preferably 1 to 5 parts by weight relative to 100 parts by weight of the rubber component, and the vulcanization accelerator is incorporated so as to account for 0.1 to 10 parts by weight, or preferably 1 to 5 parts by weight relative to 100 parts by weight of a rubber component.

A rubber composition for an electromagnetic wave absorber of the present invention may contain natural rubber (NR), one or more of various kinds of synthetic rubbers including styrene-butadiene rubber (SBR), butadiene rubber, isoprene rubber, chloroprene rubber, butyl rubber (IIR), halogenated butyl rubber, brominated(isobutylene/4-methylstyrene copolymer), ethylene-propylene rubber, acrylic rubber, chlorosulfonated polyethylene rubber, fluorine rubber latex, silicone rubber latex and urethane rubber latex, as well as SBS (styrene-butadiene-styrene), SEBS (styrene-(ethylene-butadiene)-styrene) or other thermoplastic elastomers as its rubber component, but in particular the use of natural rubber is preferable.

The rubber composition for an electromagnetic wave absorber may contain magnetic materials other than carbonyl iron, such as ferrite powder. However, also in such a case, it is advisable that the other magnetic materials are incorporated so as to account for 1700 wt% or lower, or preferably 1200 wt% or lower of the total quantity of the carbonyl iron and the other magnetic materials, in order to ensure the excellent electromagnetic wave absorbance properties provided by the carbonyl iron.

When preparing the rubber composition for an electromagnetic wave absorber, it is allowed to add and knead components other than carbonyl iron (if other magnetic materials are used, components other than carbonyl iron and the magnetic materials) into the rubber component in advance, followed by adding and kneading the carbonyl iron in two or more separate steps. By uniformly dispersing fine powder of carbonyl iron in the rubber matrix, a rubber composition for an electromagnetic wave absorber that is excellent in uniformity of electromagnetic wave absorbance properties can be obtained. In particular, it is preferable to add and knead carbonyl iron in multiple steps so that the quantity of carbonyl iron added and kneaded in each step is 100 to 200 parts by weight relative to 100 parts by weight of the rubber component.

By shaping the rubber composition for an electromagnetic wave absorber into a sheet by vulcanization, an electromagnetic wave absorbing sheet is produced. For applications of the electromagnetic wave absorbing sheet as an electromagnetic wave absorber for ETCs, it is preferable to design the sheet so that it shows preferably 80 degrees or lower of hardness according to JIS K6253 (Type A) and 15 dB or higher of 5.8 GHz electromagnetic wave absorbance amount when its thickness is 3 mm or lower, or more preferably, it has 2.0 mm or lower of thickness and exhibits 75 degrees or lower of hardness and 20 dB or higher of 5.8 GHz electromagnetic wave absorbance amount.

The electromagnetic wave absorbing sheet may be used in a laminated form with electromagnetic wave absorbing sheets in other configurations, and if required, an adhesive layer or a sticking layer is formed on the back surface or a design layer is formed on the front surface for practical use.

### Examples 1 and 2, and Comparative Examples 1 to 5

In Examples 1 and 2 as well as Comparative Examples 1 to 5 described below, the standard rubber formulation shown in the following Table 1 was employed.

**[Table 1]**

| Standard rubber formulation | (parts by weight) |
|---|---|
| Natural rubber | 100 |
| Stearic acid | 1 |
| Zinc oxide | 5 |
| Microcrystalline wax | 1 . 2 |
| Anti-aging agent 6C | 1 |
| Aromatic oil | 9 |
| Insoluble sulfur | 1. 5 |
| Vulcanization accelerator CZ | 1. 2 |

Detailed descriptions of carbonyl iron and M-type ferrite used in Examples 1 and 2 as well as Comparative Examples 1 to 5 are as follows.
Carbonyl iron:"S-1641" manufactured by ISP Japan Ltd. Mean particle diameter 3 to 6 µm
M-type ferrite: "EWA-1-V" manufactured by Nippon Bengara Kogyo Co., Ltd.
Mean particle diameter 2.9 µm

### Examples 1 and 2, and Comparative Examples 1 to 5

Rubber compositions for an electromagnetic wave absorber were prepared by adding and kneading either carbonyl iron or M-type ferrite into the rubber formulation shown in Table 1, according to the proportions and the number of additions indicated in Table 2 (The amount used in each addition is represented by the quantity obtained by dividing the incorporating amount by the number of additions. Therefore, in Examples 1 and 2, carbonyl iron is added to a formulation obtained by adding and kneading components other than carbonyl iron in a manner where the amount of the carbonyl iron used in each addition is 125 parts by weight relative to 100 parts by weight of the natural rubber). By shaping these rubber compositions for an electromagnetic wave absorber into a certain form by vulcanization, electromagnetic wave absorbing sheets with the thickness indicated in Table 2 were obtained (Note that in Comparative Example 1 it was impossible to shape the rubber composition into a sheet).

For each rubber composition for an electromagnetic wave absorber, dispersity was macroscopically evaluated and classified into Good or Not good (NG), hardness was measured according to JIS K6253 (Type A), and 5.8 GHz electromagnetic wave absorbance amount of each electromagnetic wave absorbing sheet was determined by the power reflection method. The results are shown in Table 2.

**[Table 2]**

| Example | | Examples | | Comparative Example | | | | |
|---|---|---|---|---|---|---|---|---|
| | | 1 | 2 | 1 | 2 | 3 | 4 | 5 |
| Incorporating amount (parts by weight) | Carbonyl iron | 500 | 1000 | - | - | - | 180 | 500 |
| | M-type ferrite | - | - | 180 | 500 | 1000 | - | - |
| No. of additions | | 4 | 8 | 1 | 4 | 8 | 1 | 1 |
| Dispersity | | Good | Good | Good | Good | Good | Good | NG |
| Electromagnetic wave absorbing sheet thickness (mm) | | 2.6 | 1.5 | 16. 5 | 3.9 | 3.0 | 14.5 | Not determined |
| Hardness (degree) | | 55 | 73 | 51 | 72 | 81 | 44 | Not determined |
| 5.8 GHz electromagnetic wave absorbance amount (dB) | | 15.7 | 20.7 | 22.5 | 22.2 | 23.7 | 28.6 | Not determined |

Table 2 clearly indicates the following facts. When M-type ferrite is used, Comparative Example 1 incorporating a lower amount of the ferrite exhibits lower hardness, but shows relatively poor electromagnetic wave absorbance properties and greater thickness. In Comparative Examples 2 and 3, the sheet thickness is reduced as the amount of the M-type ferrite incorporated is increased, but the hardness is increased, resulting in flexibility degradation. When carbonyl iron is incorporated, Comparative Example 4 with a lower incorporation amount exhibits lower hardness and is thus flexible, but it shows poor electromagnetic wave absorbance properties and greater sheet thickness.

In Comparative Example 5, where the entire amount of carbonyl iron is added at one time, the carbonyl iron does not uniformly disperse in the natural rubber, so that it is impossible to obtain a kneaded rubber sheet due to its poor dispersity.

On the other hand, Examples 1 and 2, which incorporate carbonyl iron in an amount that accounts for 500 parts by weight or 1000 parts by weight to 100 parts by weight of the natural rubber, satisfy the requirements of electromagnetic wave absorbance properties at 15 dB or higher when the sheet thickness is 3 mm or lower, and at the same time exhibit hardness of 80 degrees or lower, thus being excellent in flexibility.

### [Rubber Composition for an Electromagnetic Wave Absorber Containing Weather-Resistant Rubber]

Rubber compositions for an electromagnetic wave absorber of the present invention may contain not less than 5 parts by weight of a weather-resistant rubber in 100 parts by weight of the rubber component.

Compositions that contain natural rubber, styrene-butadiene rubber or other kinds of general-purpose rubbers as a rubber component are less resistant to environmental conditions such as ozone, weather and heat. By incorporating not less than 5 parts by weight of a weather-resistant rubber into 100 parts by weight of the rubber component, resistance to environmental conditions such as ozone, weather and heat can be improved.

Therefore, electromagnetic wave absorbing sheets produced from this rubber composition are highly resistant to environmental conditions such as ozone, weather and heat while only having a small thickness. Utilizing the electromagnetic wave absorbing sheets, it is possible to take measures easily for shielding against electromagnetic waves with long-term durability.

Examples of the weather-resistant rubber include butyl rubber, chloroprene rubber, ethylene-propylene rubber, ethylene-propylene-diene rubber, chlorinated polyethylene rubber, acrylonitrile-butadiene rubber, chlorinated butyl rubber, brominated butyl rubber, and chlorosulfonated polyethylene rubber. The weather-resistant rubbers may be used separately or in combination of two or more kinds.

The weather-resistant rubber is preferably contained at 20 parts by weight or more in 100 parts by weight of the rubber component, in particular, to sufficiently improve the resistance to environmental conditions.

As described above, the use of a weather-resistant rubber as the rubber component may improve the resistance to environmental conditions of the electromagnetic wave absorbing sheet, but flexibility and processability thereof may be decreased. In such cases, therefore, it is advisable to use a general-purpose rubber as an additional rubber component to ensure essential flexibility and processability. Examples of the general-purpose rubber include natural rubber, styrene-butadiene rubber, isoprene rubber and butadiene rubber, and the general-purpose rubbers may be used separately or in combination of two or more kinds.

Proportion of the general-purpose rubber to the weather-resistant rubber contained in the rubber component is determined within the range of general-purpose rubber/weather-resistant rubber = 95/5 to 5/95 (w/w), more preferably, 80/20 to 55/45 (w/w), depending on properties required for the obtained rubber compositions for an electromagnetic wave absorber. It is preferable to incorporate a greater amount of the weather-resistant rubber if the emphasis is on the resistance to environmental conditions, and to incorporate a greater amount of the general-purpose rubber if the emphasis is on flexibility and processability.

The rubber component may contain rubbers other than the weather-resistant rubber and the general-purpose rubber described above, such as brominated(isobutylene/4-methylstyrene copolymer), acrylic rubber, fluorine rubber latex, silicone rubber latex and urethane rubber latex, which may be used separately or in combination of two or more kinds, as well as SBS (styrene-butadiene-styrene), SEBS (styrene-(ethylene-butadiene)-styrene) or other thermoplastic elastomers, which may also be used separately or in combination of two or more kinds.

In particular, if natural rubber and a weather-resistant rubber such as ethylene-propylene rubber are used together as the rubber component, the obtained rubber composition for an electromagnetic wave absorber would be excellent in flexibility and processability, and at the same time have outstanding resistance to environmental conditions. In this case, if the ratio of the amount of the natural rubber incorporated in the rubber component is higher than that of the weather-resistant rubber such as ethylene-propylene rubber, improvement in the resistance to environmental conditions such as ozone, weather and heat provided by the weather-resistant rubber such as ethylene-propylene rubber may be insufficient. In contrast, when the amount of the weather-resistant rubber such as ethylene-propylene rubber incorporated in the rubber component is higher than that of the natural rubber, improvement in flexibility and processability provided by the natural rubber may be insufficient. Therefore, the proportion of the natural rubber to that of the weather-resistant rubber such as ethylene-propylene rubber contained in the rubber component is preferably 95/5 to 5/95 (natural rubber/weather-resistant rubber such as ethylene-propylene rubber; w/w), or more preferably 80/20 to 55/45 (w/w).

Examples of constituents of the rubber component other than the natural rubber in this case may include various synthetic rubbers other than the weather-resistant rubber such as ethylene-propylene rubber described above, such as styrene-butadiene rubber, butadiene rubber, isoprene rubber, brominated(isobutylene/4-methylstyrene copolymer), acrylic rubber, fluorine rubber latex, silicone rubber latex and urethane rubber latex, which may be used separately or in combination of two or more kinds, as well as SBS (styrene-butadiene-styrene), SEBS (styrene-(ethylene-butadiene)-styrene) or other thermoplastic elastomers. However, to maximize the abovementioned effect of the use of natural rubber and weather-resistant rubber such as ethylene-propylene rubber as the rubber component, it is advisable that the amount of constituents other than the natural rubber and the weather-resistant rubber such as ethylene-propylene rubber that are incorporated in the rubber component is not more than 20 parts by weight, or more preferably not more than 10 parts by weight relative to 100 parts by weight of the entire rubber component, and in particular, it is recommended that the rubber component consists of natural rubber and weather-resistant rubber such as ethylene-propylene rubber.

Furthermore, the rubber composition for an electromagnetic wave absorber may contain carbon black. Carbon black absorbs ultraviolet waves, thereby improving the resistance of the rubber to light and weather. The amount of carbon black incorporated in the rubber component is preferably 1 to 10 parts by weight relative to 100 parts by weight of the rubber component. If the amount of carbon black is less than this range, the abovementioned effect of the use of carbon black may be insufficient. Also, the use of an excessive amount of carbon black may have a negative impact on the electromagnetic wave absorbance properties and thus should be avoided.

Besides carbonyl iron and carbon black, several vulcanization agents, auxiliary agents for vulcanization, and if required, other additives that are generally used in rubber compositions, such as vulcanization accelerators, softening agents, anti-aging agents, plasticizers, mold releasing agents, hardening agents, foaming agents and coloring agents can be optionally incorporated into the rubber composition for an electromagnetic wave absorber.

Examples of the vulcanization agents and the vulcanization accelerators include the substances described above, and the preferred amounts with which they are incorporated are also the same as the aforementioned ones.

The rubber composition for an electromagnetic wave absorber may contain magnetic materials other than carbonyl iron, such as ferrite powder. However, also in such a case, it is advisable that the other magnetic materials are incorporated so as to account for 1700 wt% or lower, or preferably 1200 wt% or lower of the total quantity of the carbonyl iron and the other magnetic materials, in order to ensure the excellent electromagnetic wave absorbance properties provided by the carbonyl iron.

When preparing the rubber composition for an electromagnetic wave absorber that contains a general-purpose rubber and a weather-resistant rubber as the rubber component, it is allowed to add and knead fillers such as carbonyl iron (if carbon black is used, the carbon black is also regarded as a filler) into the weather-resistant rubber such as ethylene-propylene rubber in advance, followed by adding and kneading the general-purpose rubber such as natural rubber. By uniformly dispersing fine powder of the fillers such as carbonyl iron in the rubber matrix, a rubber composition for an electromagnetic wave absorber that is excellent in uniformity of electromagnetic wave absorbance properties and processability can be obtained. In this operation, the carbonyl iron may be added and kneaded in two or more separate steps.

By shaping the rubber composition for an electromagnetic wave absorber into a sheet by vulcanization, an electromagnetic wave absorbing sheet is produced. In particular, it is preferred to design the sheet so that it shows 80 degrees or lower of hardness according to JIS K6253 (Type A) and 15 dB or higher of 5.8 GHz electromagnetic wave absorbance amount when its thickness is 3 mm or lower. It is also preferred that the rubber composition for an electromagnetic wave absorber has no cracks after 100-hour testing for resistance to ozone according to JIS K6259.

These electromagnetic wave absorbing sheets may be used in a laminated form with electromagnetic wave absorbing sheets in other configurations, and if required, an adhesive layer or a sticking layer is formed on the back surface or a design layer is formed on the front surface for practical use.

The rubber composition for an electromagnetic wave absorber that contains a weather-resistant rubber is specifically described below, with reference to Examples and Comparative Examples.

### Examples 3 to 7, and Comparative Examples 6 and 7

The electromagnetic wave absorbing sheets with thicknesses indicated in Table 3 were obtained by preparing a rubber composition for an electromagnetic wave absorber according to the rubber formulation shown in Table 3, followed by shaping the obtained rubber composition for the electromagnetic wave absorber by vulcanization. As for Examples 3 to 6 and Comparative Example 7, the components other than natural rubber were added and kneaded into ethylene-propylene rubber prior to the addition and kneading of the natural rubber (2-step kneading). As for Comparative Example 6 and Example 7, all the components were added and kneaded at the same time (1-step kneading).

Individual rubber compositions for an electromagnetic wave absorber and electromagnetic wave absorbing sheets were evaluated for the following properties. The results are shown in Table 3.
Dispersity: Dispersity was macroscopically evaluated and classified into "VG" in the case the carbonyl iron was uniformly dispersed and the good dispersity was achieved, "G" in the case the dispersity was rather poor due to slight aggregation of the carbonyl iron, and "NG" in the case the dispersity was poor due to aggregation of the carbonyl iron. Less dispersity means less processability.
Hardness: Hardness of the electromagnetic wave absorbing sheets was measured according to JIS K6253 (Type A).
Electromagnetic wave absorbance properties: 5.8 GHz electromagnetic wave absorbance amount of the electromagnetic wave absorbing sheets was determined by the power reflection method.
Resistance to ozone: The resistance to ozone was measured by evaluating the presence/absence of cracks after 100-hour testing according to JIS K6259.

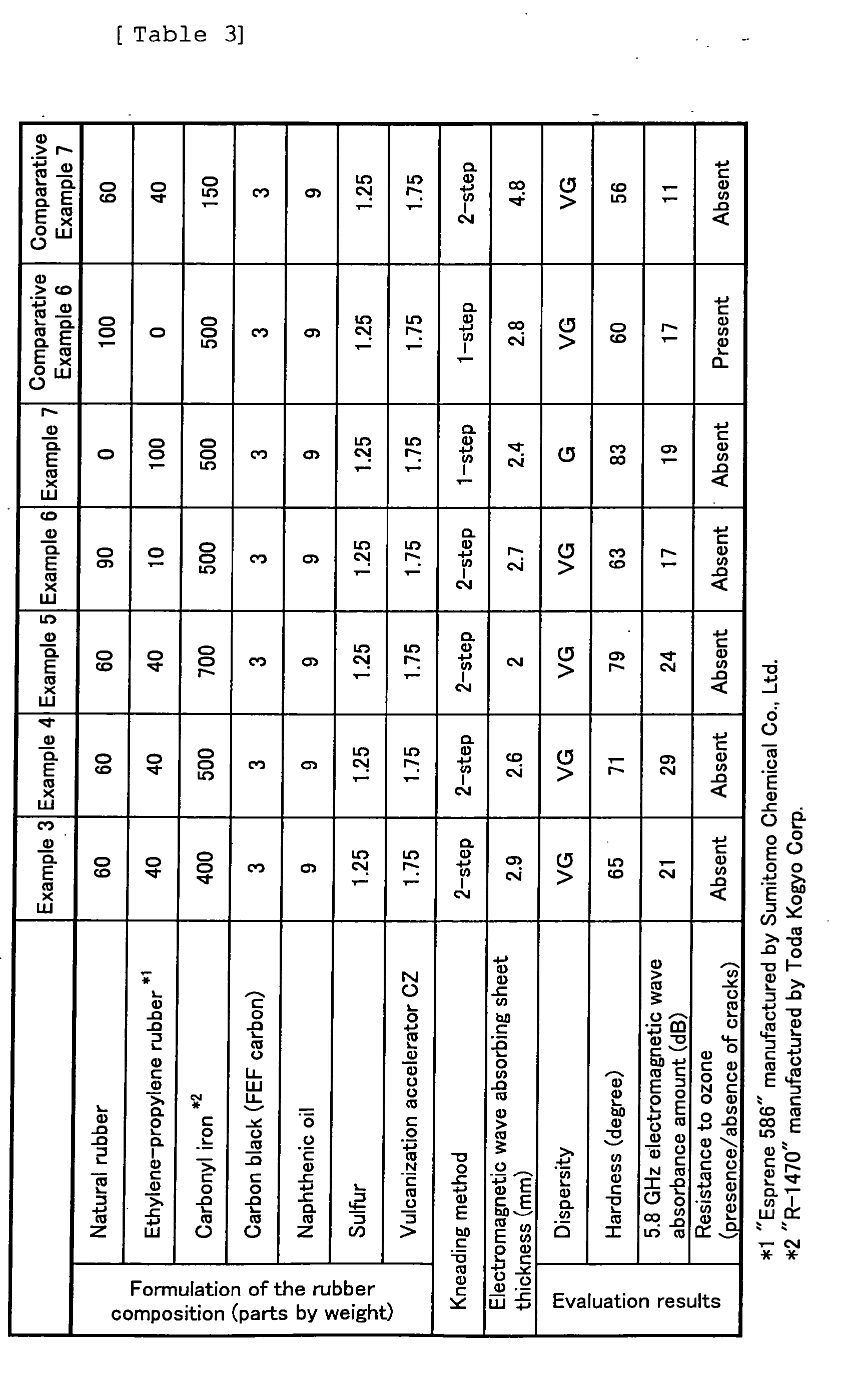

Table 3 clearly indicates the following facts.

Comparative Example 6 is a natural rubber formulation system and thus is good in terms of carbonyl iron dispersity, is flexible with low hardness and has favorable electromagnetic wave absorbance properties, though it is less resistant to ozone. On the other hand, Comparative Example 7 is poor in electromagnetic wave absorbance properties because of incorporation of a small amount of carbonyl iron. In contrast, Examples 3 to 6, which are blended formulations of natural rubber and ethylene-propylene rubber, satisfy all the requirements of dispersity, hardness, electromagnetic wave absorbance properties, and resistance to ozone. In addition, they achieved more favorable electromagnetic wave absorbance properties than the natural rubber formulation systems. Furthermore, although Example 7 is an ethylene-propylene rubber formulation system and thus poor in both dispersity and flexibility, it achieved favorable electromagnetic wave absorbance properties and resistance to ozone.

### Examples 8 to 13

The electromagnetic wave absorbing sheets with thicknesses indicated in Tables 4 to 8 were obtained by preparing rubber compositions for an electromagnetic wave absorber according to the rubber formulations shown in Tables 4 to 8, followed by shaping the obtained rubber compositions for an electromagnetic wave absorber by vulcanization. All the components were added and kneaded at the same time (1-step kneading) in preparation of Examples 8 to 13.

Individual electromagnetic wave absorbing sheets were evaluated for hardness, electromagnetic wave absorbance properties and resistance to ozone in a similar way to that in Example 1. The results are shown in Tables 4 to 8.

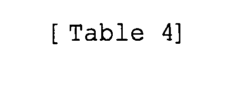

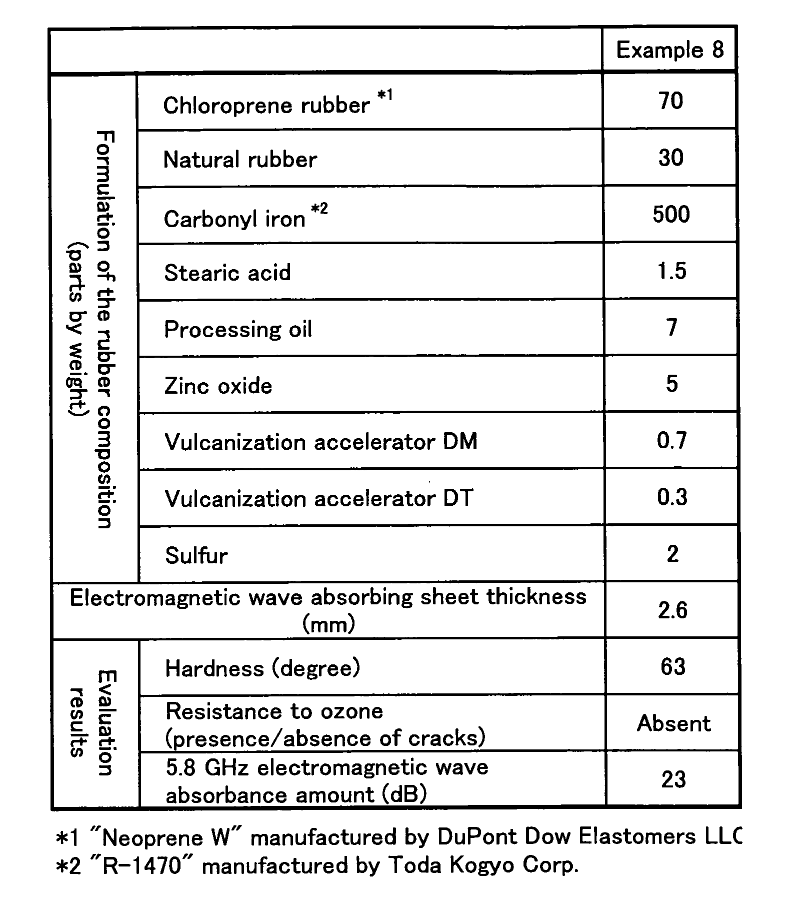

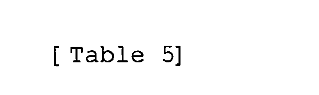

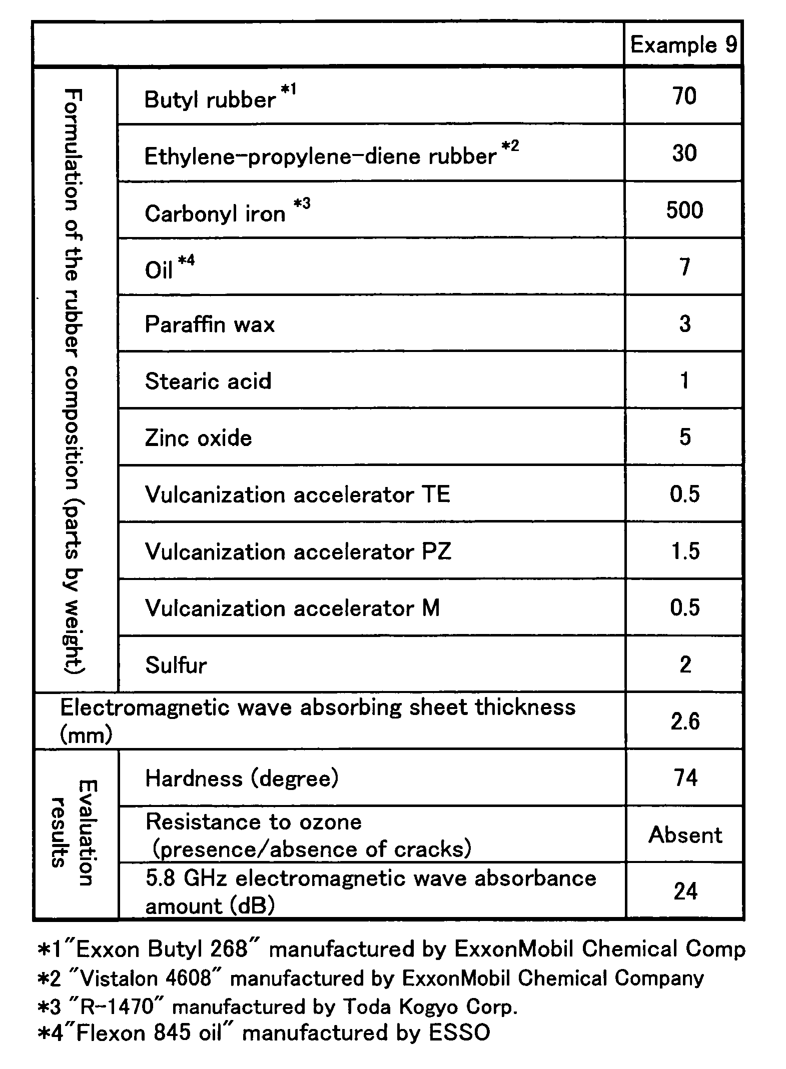

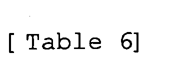

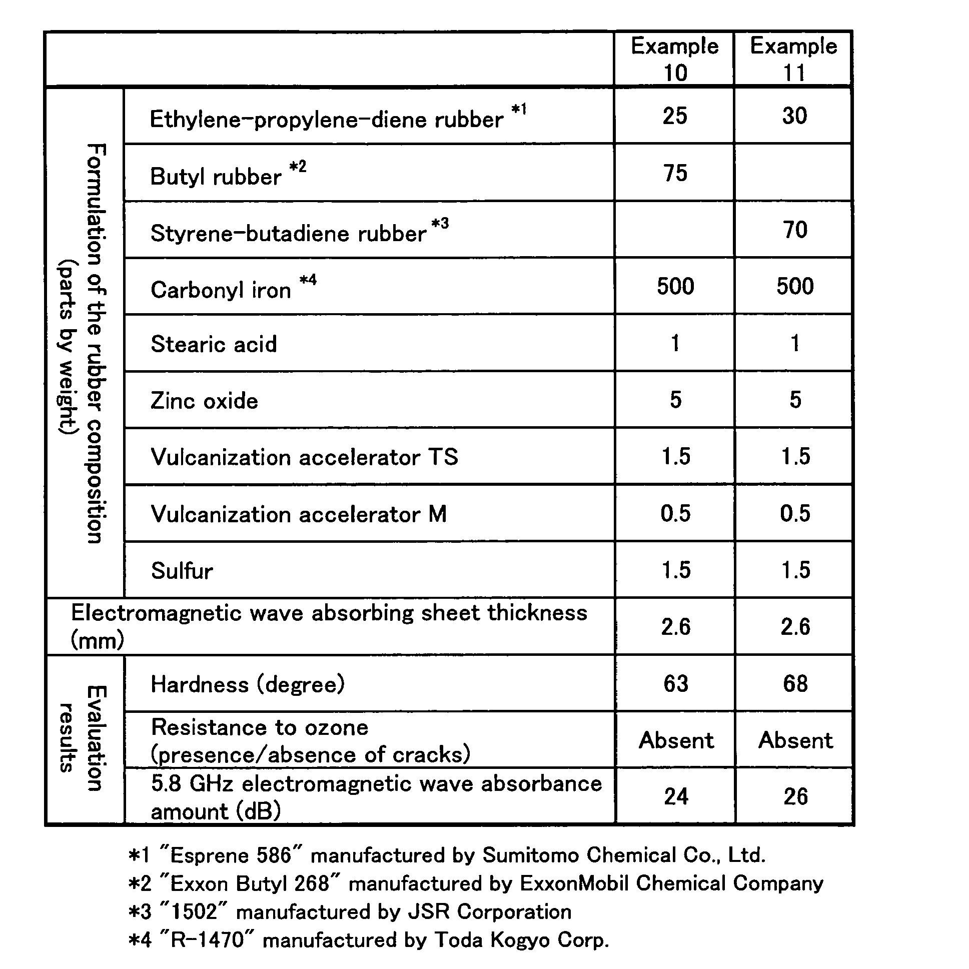

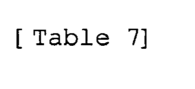

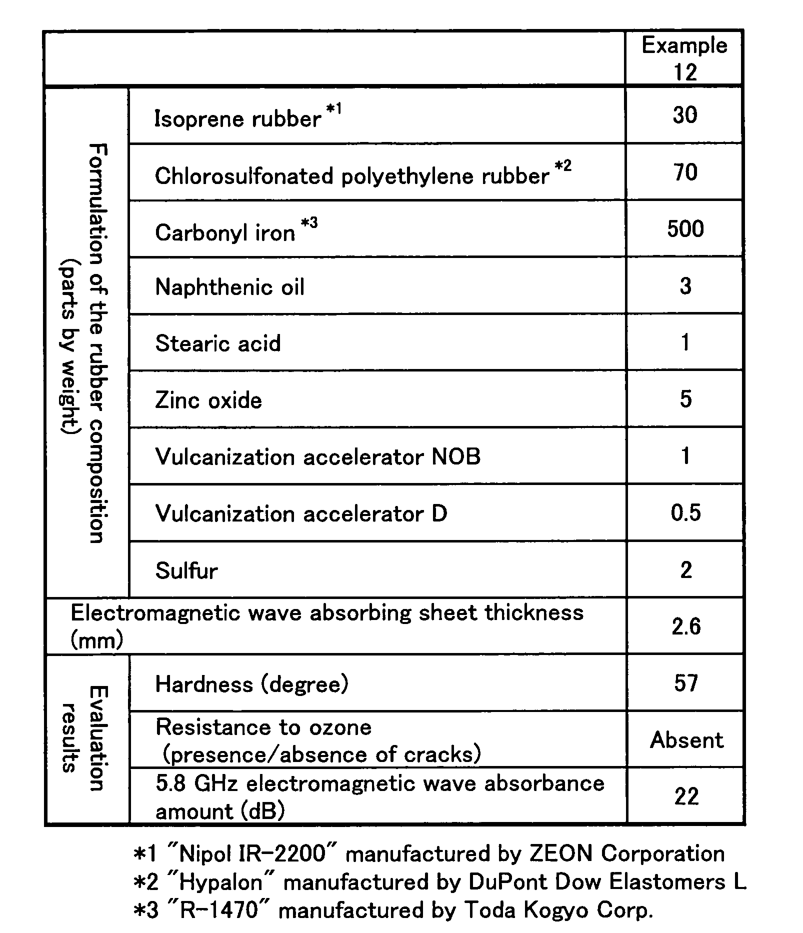

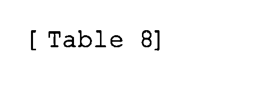

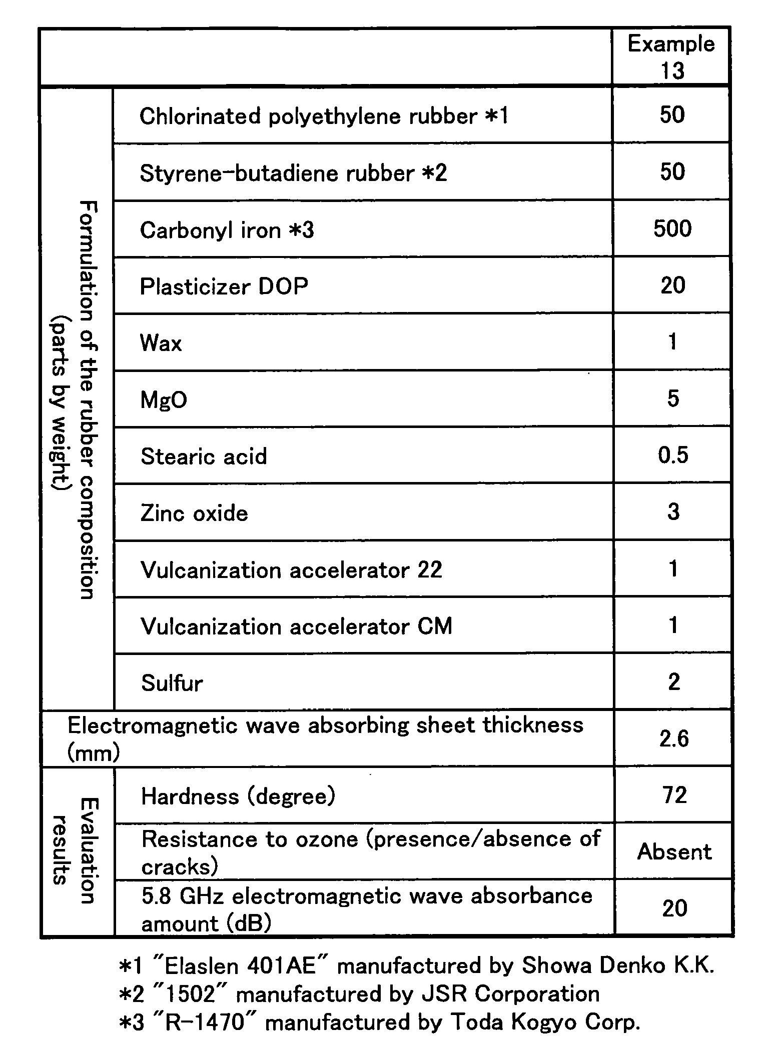

In Tables 4 to 8, it is found that the rubber composition for an electromagnetic wave absorber of the present invention that contains a weather-resistant rubber as the rubber component provides electromagnetic wave absorbing sheets excellent in both electromagnetic wave absorbance properties and resistance to ozone.

## Claims

1. A rubber composition for an electromagnetic wave absorber comprising 100 parts by weight of a rubber component and 200 to 1500 parts by weight of carbonyl iron.

2. The rubber composition for an electromagnetic wave absorber according to Claim 1, wherein the rubber component is natural rubber.

3. The rubber composition for an electromagnetic wave absorber according to Claim 1, wherein 500 to 1000 parts by weight of the carbonyl iron is contained relative to 100 parts by weight of the rubber component.

4. The rubber composition for an electromagnetic wave absorber according to Claim 1, wherein the mean particle diameter of the carbonyl iron is 1 to 10 µm.

5. The rubber composition for an electromagnetic wave absorber according to Claim 1, further comprising powder of a magnetic material other than the carbonyl iron.

6. The rubber composition for an electromagnetic wave absorber according to Claim 5, wherein the magnetic material is ferrite.

7. The rubber composition for an electromagnetic wave absorber according to Claim 1, wherein a component other than the carbonyl iron is added and kneaded into the rubber component, followed by addition and kneading of the carbonyl iron in two or more separate steps.

8. The rubber composition for an electromagnetic wave absorber according to Claim 7, wherein the amount of the carbonyl iron added and kneaded in each step is 100 to 200 parts by weight relative to 100 parts by weight of the rubber component.

9. An electromagnetic wave absorbing sheet prepared by shaping the rubber composition for an electromagnetic wave absorber according to Claim 1 into a sheet.

10. The electromagnetic wave absorbing sheet according to Claim 9, wherein hardness according to JIS K6253 (Type A) is 80 degrees or lower and 5.8 GHz electromagnetic wave absorbance amount is 15 dB or higher when the thickness is 3 mm or lower.

11. The rubber composition for an electromagnetic wave absorber according to Claim 1, wherein not less than 5 parts by weight of a weather-resistant rubber is contained in 100 parts by weight of the rubber component.

12. The rubber composition for an electromagnetic wave absorber according to Claim 11, wherein the weather-resistant rubber is one or more rubbers selected from the group consisting of butyl rubber, chloroprene rubber, ethylene-propylene rubber, ethylene-propylene-diene rubber, chlorinated polyethylene rubber, acrylonitrile-butadiene rubber, chlorinated butyl rubber, brominated butyl rubber, and chlorosulfonated polyethylene rubber.

13. The rubber composition for an electromagnetic wave absorber according to Claim 11, wherein not less than 20 parts by weight of a weather-resistant rubber is contained relative to 100 parts by weight of the rubber component.

14. The rubber composition for an electromagnetic wave absorber according to Claim 11, wherein the rubber component includes the weather-resistant rubber and a general-purpose rubber other than weather-resistant rubber.

15. The rubber composition for an electromagnetic wave absorber according to Claim 14, wherein the general-purpose rubber is one or more rubbers selected from the group consisting of natural rubber, styrene-butadiene rubber, isoprene rubber, and butadiene rubber.

16. The rubber composition for an electromagnetic wave absorber according to Claim 15, containing natural rubber and ethylene-propylene rubber as the rubber component in the proportions of 95/5 to 5/95 (natural rubber/ethylene-propylene rubber; w/w).

17. The rubber composition for an electromagnetic wave absorber according to Claim 16, containing the natural rubber and the ethylene-propylene rubber as the rubber component in the proportions of 80/20 to 55/45 (natural rubber/ethylene-propylene rubber; w/w).

18. The rubber composition for an electromagnetic wave absorber according to Claim 11, further comprising 1 to 10 parts by weight of carbon black relative to 100 parts by weight of the rubber component.

19. The rubber composition for an electromagnetic wave absorber according to Claim 11, wherein 300 to 1000 parts by weight of the carbonyl iron is contained relative to 100 parts by weight of the rubber component.

20. The rubber composition for an electromagnetic wave absorber according to Claim 11, wherein the mean particle diameter of the carbonyl iron is 1 to 10 µm.

21. The rubber composition for an electromagnetic wave absorber according to Claim 14, wherein fillers such as carbonyl iron are added and kneaded into the weather-resistant rubber, followed by addition and kneading of the general-purpose rubber.

22. The rubber composition for an electromagnetic wave absorber according to Claim 21, wherein the fillers such as carbonyl iron are added and kneaded into ethylene-propylene rubber, followed by addition and kneading of natural rubber.

23. An electromagnetic wave absorbing sheet prepared by shaping the rubber composition for an electromagnetic wave absorber according to Claim 11 into a sheet.
